# EUROPEAN PATENT APPLICATION

(11) **EP 3 564 807 A1**
(43) Date of publication of application: **06.11.2019**
(21) Application number: 16926039.5
(22) Date of filing: 30.12.2016
(51) Int. Cl.: G06F 3/0488

(54) **FLEXIBLE DISPLAY DEVICE CONTROL METHOD AND APPARATUS**

(71) Applicant: Shenzhen Royole Technologies Co., Ltd., Shenzhen, Guangdong 518052 (CN)
(72) Inventor: ZHANG, Xuan, Shenzhen Guangdong 518052 (CN); WU, Dan, Shenzhen Guangdong 518052 (CN)
(74) Representative: Hamer, Christopher K.
(86) International application number: PCT/CN2016/113653
(87) International publication number: WO 2018/120084

(57) **Abstract**

A method for controlling a flexible display device is performed by a flexible display screen. A display interface of the flexible display screen includes a first area and a second area upon being bent. The method includes: detecting a bending operation of the flexible display screen, and determining the first area and the second area according to the bending operation (S102); detecting a first gesture operating on the second area of the flexible display screen, and obtaining a gesture parameter of the first gesture, wherein the gesture parameter comprises at least one of a gesture type, a gesture direction, a gesture movement distance, a gesture duration, and a gesture pressure (SI04); and obtaining a target control on the first area according to the gesture parameter, and generating and performing a control command corresponding to the target control (SI06). Gesture control manners of the flexible display device may become richer, thus providing more application space for the flexible display screen and further improving user experience.

## Description

### TECHNICAL FIELD

The present disclosure relates to the technical field of a flexible display device, and more particularly to a method and device for controlling a flexible display device.

### BACKGROUND

Currently, common interactive modes of electronic devices include touch and click interaction. With the rise of flexible display screens in recent years, it will bring possibilities of many new gestures, and gesture interactions may be more intuitive and easy to use. Most of the existing flexible display screens use flexible OLED technology, which have bendable, twistable and foldable characteristics, thus a high-resolution and large-sized area and the portability of the devices may be no longer contradictory, durable programs may be also significantly higher than previous screens, and a probability of accidental damage of the device may be reduced.

In a typical usage, the current flexible display screens are generally operated by a clicking operation, a sliding operation, and the like on an icon or interface of a display area. Operating modes of the current flexible display screens are basically the same as that of current common display screens, which include that an interactive control mode is single, and functions are not rich enough, thus causing an insufficient diversity of the operation, and degrading the user experience.

### SUMMARY

Based on this, in order to solve a problem that an interactive mode of a display screen of a flexible display device is single and a diversity of operation of the display screen of the flexible display device is insufficient, an embodiment of the present disclosure aims to provide a method for controlling a flexible display device.

A method for controlling a flexible display device is performed by a flexible display screen. A display interface of the flexible display screen includes a first area and a second area upon being bent. The method includes:
detecting a bending operation of the flexible display screen, and determining the first area and the second area according to the bending operation;
detecting a first gesture operating on the second area of the flexible display screen, and obtaining a gesture parameter of the first gesture, where the gesture parameter includes at least one of a gesture type, a gesture direction, a gesture movement distance, a gesture duration, and a gesture pressure; and
obtaining a target control on the first area according to the gesture parameter, and generating and performing a control command corresponding to the target control.

In addition, in order to solve a problem that an interactive mode of a display screen of a flexible display device is single and a diversity of operation of the display screen of the flexible display device is insufficient, an embodiment of the present disclosure aims to provide a device for controlling a flexible display device.

A device for controlling a flexible display device includes:
a bending operation detection module configured to detect a bending operation of the flexible display screen, and determine the first area and the second area according to the bending operation;
a first gesture obtaining module configured to detect a first gesture operating on the second area of the flexible display screen, and obtain a gesture parameter of the first gesture, where the gesture parameter includes at least one of a gesture type, a gesture direction, a gesture movement distance, a gesture duration, and a gesture pressure; and
a gesture control module configured to obtain a target control on the first area according to the gesture parameter, and generate and perform a control command corresponding to the target control.

Implementation of the embodiments of the present disclosure will have the following beneficial effects:

In an embodiment of the present disclosure, a bending operation of a flexible display screen is detected, and a first area and a second area are determined according to the bending operation. A first gesture operating on the second area of the flexible display screen is detected, and a gesture parameter of the first gesture is obtained. The gesture parameter includes at least one of a gesture type, a gesture direction, a gesture movement distance, a gesture duration, and a gesture pressure. A target control on the first area is obtained according to the gesture parameter , and a control command corresponding to the target control is generated and performed. In some application scene that a cursor position needs to control accurately, the embodiment of the present disclosure may be implemented. Since a gesture on the second area corresponds to the cursor on the first area, the gesture operation can be performed on the second display area, and a control on the first area can be controlled, thus making the gesture control more accurate, and reducing a misoperation. At the same time, because a combination between a gesture control on the first area and a gesture control on the second area is provided, a diversity of the gesture operation is increased, thus providing more application space for the flexible display screen, and further improving the user experience.

### BRIEF DESCRIPTION OF THE DRAWINGS

In order to more clearly illustrate the technical solution of the present disclosure or technical solutions of the prior art, the accompanying drawings required for describing the embodiments or the prior art will be briefly described below. Apparently, the accompanying drawings in the following description are merely the embodiments of the present disclosure, and other drawings may be obtained by those skilled in the art according to these accompanying drawings without paying any creative labor.
FIG. 1 is a flowchart of a method for controlling a flexible display device provided by an exemplary embodiment of the present disclosure.
FIG. 2 is a schematic view of a flexible display device provided by an exemplary embodiment of the present disclosure.
FIG. 3 is a schematic view of a gesture of the flexible display device provided by an exemplary embodiment of the present disclosure.
FIG. 4 is a schematic view of a gesture of the flexible display device provided by an exemplary embodiment of the present disclosure.
FIG. 5 is a schematic view of a gesture of the flexible display device provided by an exemplary embodiment of the present disclosure.
FIG. 6 is a schematic view of a gesture of the flexible display device provided by an exemplary embodiment of the present disclosure.
FIG. 7 is a structural schematic view of a device for controlling a flexible display device provided by an exemplary embodiment of the present disclosure.
FIG. 8 is a hardware architecture diagram of a computer system for operating the method for controlling a flexible display device provided by an exemplary embodiment of the present disclosure.

### DETAILED DESCRIPTION

The technical solutions in the embodiments of the present disclosure will be clearly and completely described in the following with reference to the accompanying drawings in the embodiments of the present disclosure. Apparently, the described embodiments are merely some but not all of the embodiments of the present disclosure. All other embodiments obtained by a person of ordinary skill in the art based on the embodiments of the present disclosure without creative efforts shall fall within the protection scope of the present disclosure.

It should be noted that, the terms used in the embodiments of the present disclosure are merely configured to describe the specific embodiments and is not intended to limit the present disclosure. The singular forms "a" and "the" used in the embodiments of the present disclosure and dependent claims are intended to include the plural forms as well, unless the context clearly indicates other meanings. It should also be understood that, the term "and/or" as used herein refers to and includes any and all possible combinations of one or more of the associated listed items.

In order to solve a problem that an interactive mode of a display screen of a flexible display device is single and a diversity of operation of the display screen of the flexible display device is insufficient, an embodiment of the present disclosure aims to provide a method for controlling a flexible display device. An implementation of the method may rely on a computer program. The computer program may be a driver manager or a virtual device manager of the flexible display screen. The computer program can run on a computer system based on a von Neumann computer system. The computer program can be a terminal device with the flexible display screen, such as a personal computer, a notebook computer, a tablet computer, and a smart phone.

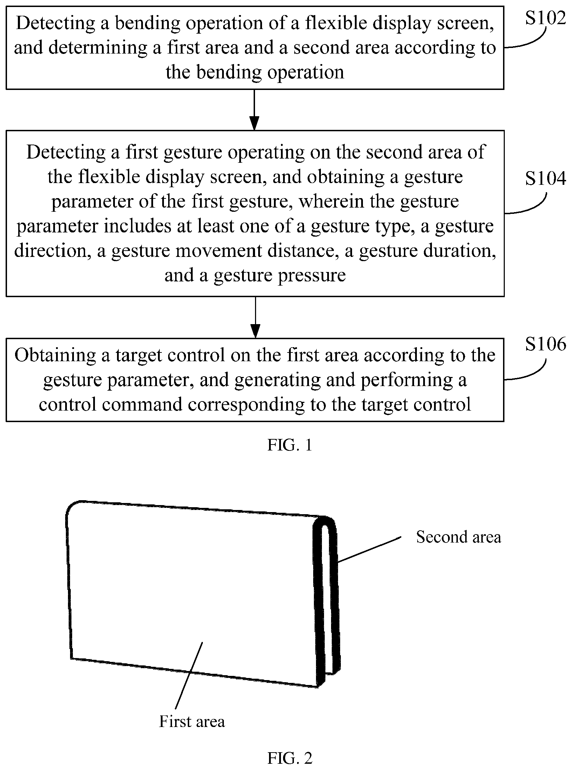

As illustrated in FIG. 1, FIG. 1 is a flowchart of a method for controlling a flexible display device provided by an exemplary embodiment of the present disclosure, and the method includes the following steps.

At block S102, a bending operation of a flexible display screen is detected, and a first area and a second area are determined according to the bending operation.

As illustrated in FIG. 2, in an embodiment, the flexible display screen is in a folded state. After bending the flexible display screen, a display area of the flexible display screen is divided into two areas (that is the first area and the second area). The first area may be configured for both touch control and display. The second area may only be configured for touch control, and a display function of the second area is not limited. In other embodiments, the second display area may also be configured for both touch control and display.

At block S104, a first gesture operating on the second area of the flexible display screen is detected, and a gesture parameter of the first gesture is obtained. The gesture parameter includes at least one of a gesture type, a gesture direction, a gesture movement distance, a gesture duration, and a gesture pressure.

In the embodiment, the gesture type of the first gesture operated on the second area may be at least one of sliding, a click, a long pressing, and multi touch. The gesture direction of the first gesture may be a sliding direction of a sliding gesture, such as sliding up, sliding down, and the like. The gesture movement distance of the first gesture may be a sliding distance of the gesture, such as, a sliding distance of 2cm on the second area. The gesture duration may be time that the gesture touches on a screen detected by a sensor on the flexible display screen, such as a duration of 3 seconds (3s) of the long press. The gesture pressure may be a pressure detected by the sensor on the flexible display screen, such as a pressing pressure of 0.5N. In the embodiment, the above gesture parameters are examples in the embodiment, and the gesture parameters mentioned below may also belong to the gesture parameters in the above example. In other embodiments, the gesture parameters may also include other parameters, such as a frequency of multiple clicks.

At block S106, a target control on the first area is obtained according to the gesture parameter , and a control command corresponding to the target control is generated and performed.

In the embodiment, when the first gesture operating on the second area is detected, a cursor position on the first area or a focus position on the first area is obtained according to the gesture parameter of the first gesture, and a target control corresponding to the cursor position or the focus position is obtained. The cursor position or the focus position described herein may be, when detecting the first gesture, a position where the cursor on the first area or the focus on the first area is docked. Thus, when a gesture on the second area slides, the cursor or the focus can be moved. For example, when the first gesture on the second area is the sliding, a sliding cursor or a sliding focus may be displayed on the first area. The cursor or the focus herein may be a cursor that moves along with a text on the screen, a mouse icon configured to indicate on the screen, or a target selection box configured to skip and switch among the plurality of icons. The cursor or focus may be not limited in the embodiment.

In an embodiment, a corresponding effect may be generated in response to a gesture operation in conjunction with a current interface of the first area. For example, when the current interface of the first area displays a music player, and when the gesture slides to the right on the second area, the music player is adjusted to play the next song; and when the gesture slides to the left on the second area, the music player is adjusted to play the previous song.

For another example, when the current interface of the first area displays an e-book reader, the gesture slides to the right or the left on the second area, to allow the e-book on the first area to be turned left and right. The number of page turning corresponds to a sliding distance of the gesture. For example, when the sliding distance that the gesture slides to the right is 3cm, a length of the second area from a left side to a right side is 10cm, a corresponding ratio is 30%, and the total number of pages of the book is assumed to be 1000, the corresponding page number of pages turned backward is 300.

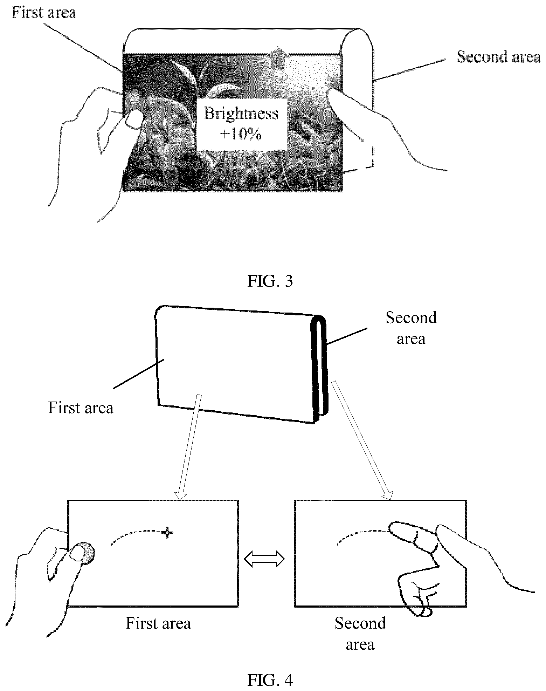

For another example, as illustrated in FIG. 3, when the first area is set to be a photo editing interface, a brightness of a displayed page may be increased with the gesture slipped up on the second area. Correspondingly, an interface on the first area is zoomed out or zoomed in by closing or releasing two fingers, which generates more convenient operation gestures, thus improving the user experience.

In the embodiment, after a cursor or a focus is initiated on the first area, the cursor or the focus on the first area can move accordingly in response to a gesture operation on the second area. The movement of the cursor or focus corresponds to the gesture operation on the second area. For example, as illustrated in FIG. 4, when a gesture slides a corresponding distance on the second area, a moving trajectory of the cursor or a moving trajectory of the focus on the first area is the same as a sliding trajectory of the gesture.

In an embodiment, when the cursor on the first area does not point to a control, such as an operable application and an operable icon, the cursor may be as a target control on the first area, and then when a gesture on the second area slides, the cursor on the first area can be moved. When the cursor on the first area points to the control, such as the operable application and the operable icon, the pointed control may be as a target control, and then when an operation of the first gesture, such as a click, is detected again, the target control can be initiated.

In another embodiment, a range of movement of the cursor or a range of movement of the focus is proportional to a range of movement of the gesture. For example, when a long text is edited and a font is small relatively, a sliding distance of a finger on the second area is 1cm, then a sliding distance of the cursor on the first area is 1mm, thus allowing more accurate control over the cursor of the first area.

In an embodiment, a corresponding display content may be generated according to a pressure of the first gesture. For example, when a movie playing interface is played on the first area, and a long press is applied to the second area, a movie scene displayed on the first area can be fast forwarded as a pressure of the first gesture increases. The higher the pressure of the first gesture becomes, the faster the movie plays. In other embodiments, different effects may be generated according to a combination of a pressure of the first gesture and a pressing position of the first gesture. For example, when a central area is pressed, the higher a pressure of the first gesture becomes, then the faster the screen expands outward from the center area, which generates more control manners, thus increasing a diversity of operation.

In an embodiment, when a target selection box is displayed on the first area, and a first gesture detected on the second area is a sliding, a position of the target selection box on the first area can move with the first gesture. When moving to a memo icon, the memo icon may be as a target control. At this time, the first gesture is converted into a click. When clicking the memo icon, a corresponding control command may be a control command that opens the memo.

In another embodiment, a current interface on the first area displays a notepad. When a cursor is moved to a target position, text content is selected in response to a long pressing and drag operation of the cursor, which can be cut, copied, or edited by other manners as needed.

In an embodiment, when a second gesture operating on the first area is detected within a preset first time threshold, a target control is obtained according to the first gesture and the second gesture, then a control command corresponding to the target control is generated and performed.

The preset first time threshold herein is defined as a threshold of a time interval between the first gesture operated on the second area and the second gesture operated on the first area. In a first case, the first gesture and the second gesture may be operated simultaneously, and the gesture parameter of the first gesture and the gesture parameter of the second gesture are superimposed on each other to generate a control command. In a second case, the first gesture may be operated first, then the second gesture is operated within a certain time threshold, and the first gesture and the second gesture are superimposed on each other to generate a control command. In a third case, the second gesture may be operated first, then the first gesture is operated within a certain time threshold, and the first gesture and the second gesture are superimposed on each other to generate a control command.

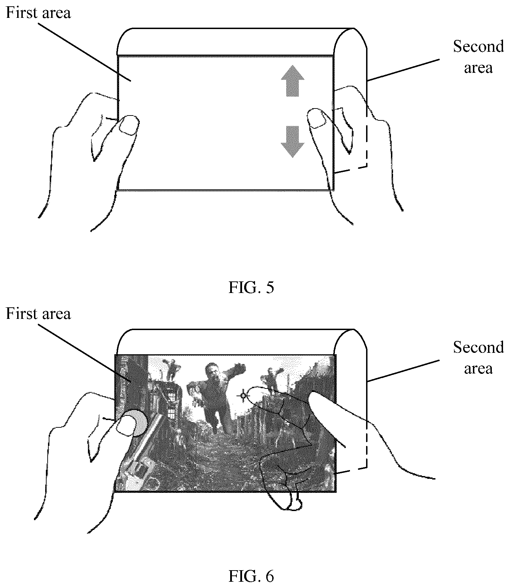

For example, as illustrated in FIG. 5, the first gesture detected on the second area slides up 2cm, while the second gesture performed detected on the first area slides up 3cm, then after a superposition therebetween, the corresponding effect on the first area is that the cursor slides up 5cm. For another example, the first gesture on the second area is zooming, and the second gesture on the first area is a click, then an effect, after the superposition therebetween, is to zoom around a central where the second gesture clicks.

As illustrated in FIG. 6, for example, in an embodiment, the current interface on the first area displays a shooting game. When a cursor is moved to a target position in response to the first gesture on the second area, the finger continues to click on the first area to generate a shooting effect in the game.

In another embodiment, the current interface on the first area displays a webpage. When webpage fonts are small relatively, a cursor may be moved to a position of a target control according to a correspondence relationship between a sliding distance of the cursor and a sliding distance of the gesture. For example, a sliding distance of the finger on the second area is 1cm, and the sliding distance of the cursor on the first area is 1mm, then a target link is clicked.

In the embodiment, an initiate of a cursor may be that, when a third gesture operating on the second area is detected, the cursor is displayed on the first area of a flexible display screen. The third gesture herein may be a preset specific gesture, such as a double click and a long pressing. The preset gesture can also be set to be a gesture pressing a certain duration. For example, when the duration of the long pressing is up to 5 seconds (5S), a display of the cursor on the first area is initiated. For another example, the third gesture may be determined by detecting a sliding distance, a sliding direction, and a pressing pressure of a gesture. For example, when the gesture slides up 3cm, and the pressing pressure exceeds IN, it may be considered that the display of the cursor on the first area is initiated.

In an embodiment, a window identifier of a window object may be obtained by detecting the window object displayed in the first area. When the window identifier matches with a preset value, the cursor is displayed in an area corresponding to the window object in the first area. For example, a preset value set by a system includes "memo". When the window object displayed in the first area is a memo, a corresponding window identifier can be obtained as the "memo", which matches with the preset value. At this time, the system automatically displays the cursor on a memo interface in the first area.

Similarly, when a long text is edited, such as a notebook, a diary application, or some shooting games, the specific application or window identifier of the interface may be preset in the system in advance. When it is detected that the window identifier on the first area matches with the preset value, the cursor is automatically displayed, thus simplifying operation.

In an embodiment, a duration of the first gesture, the second gesture, or the third gesture may also be detected. When the duration of the first gesture, the second gesture, or the third gesture is less than a second time threshold, it is determined that the detected gesture is a misoperation, and the corresponding steps are not performed. For example, when the first gesture is a click, the second time threshold preset by the system for the clicking operation is greater than 0.5s. In fact, when a user is on one click, a duration of the clicking operation detected the system is 0.1s, which is less than the preset second time threshold, then it is determined that the clicking operation is invalid, thus avoiding a problem that the misoperation causes an error during the process of performing subsequent steps.

In the embodiment, the first gesture, the second gesture, or the third gesture includes at least one of a sliding, a click, a long pressing, and multi-touch. A certain sliding distance, a sliding direction, a pressing pressure, the number of clicks, a frequency of clicks, and the like may be set between different gestures, which are not limited to examples disclosed in the above embodiments.

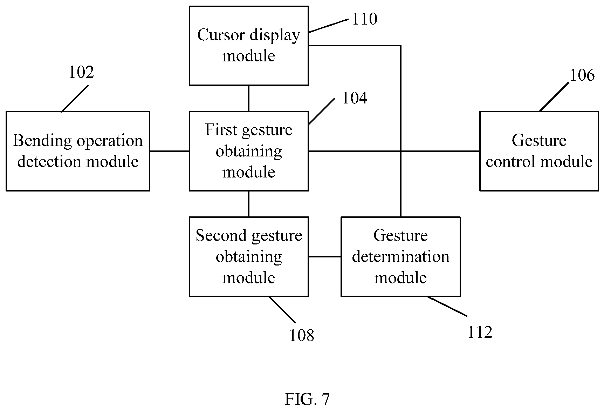

In addition, in order to solve a problem that an interactive mode of a display screen of a flexible display device is single and a diversity of operation of the display screen of the flexible display device is insufficient, a control device of a flexible display device is provided. As illustrated in FIG.7, the control device of the flexible display device includes a bending operation detection module 102, a first gesture obtaining module 104, a gesture control module 106, a second gesture obtaining module 108, a cursor display module 110, and a gesture determination module 112.

The bending operation detection module 102 is configured to detect a bending operation of the flexible display screen, and determine the first area and the second area according to the bending operation.

The first gesture obtaining module 104 is configured to detect a first gesture operating on the second area of the flexible display screen, and obtain a gesture parameter of the first gesture, wherein the gesture parameter comprises at least one of a gesture type, a gesture direction, a gesture movement distance, a gesture duration, and a gesture pressure.

The gesture control module 106 is configured to obtain a target control on the first area according to the gesture parameter, and generate and perform a control command corresponding to the target control.

Alternatively, the first gesture obtaining module 104 is further configured to obtain a cursor or focus position on the first area according to the gesture parameter of the first gesture, and obtain a target control corresponding to the cursor or focus position.

Alternatively, the device further includes a second gesture obtaining module 108 configured to, when a second gesture operating on the first area is detected within a preset first time threshold, obtain the target control on the first area according to the first gesture and a the second gesture, then generate and perform the control command corresponding to the target control.

Alternatively, the device further includes a cursor display module 110 configured to, when a third gesture operating on the second area of the flexible display screen is detected, display a cursor on the first area of the flexible display screen.

Alternatively, the cursor display module 100 is further configured to detect a window object displayed on the first area, and obtain a window identifier of the window object; when the window identifier matches a preset value, display a cursor on an area of the first area corresponding to the window object.

Alternatively, the device further includes a gesture determination module 112 configured to obtain a gesture duration of the first gesture, the second gesture, or the third gesture, and when the gesture duration is less than a preset second time threshold, determining that the first gesture, the second gesture, or the third gesture is invalid.

Alternatively, the gesture types of the first gesture, the second gesture, and the third gesture includes at least one of a sliding, a click, a long pressing, and multi touch.

Implementation of the embodiments of the present disclosure will have the following beneficial effects:

In an embodiment of the present disclosure, a bending operation of the flexible display screen is detected, and the first area and the second area are determined according to the bending operation. A first gesture operating on the second area of the flexible display screen is detected, and a gesture parameter of the first gesture is obtained. The gesture parameter includes at least one of a gesture type, a gesture direction, a gesture movement distance, a gesture duration, and a gesture pressure. A target control on the first area is obtained according to the gesture parameter, and a control command corresponding to the target control is generated and performed. In some application scene that a cursor position needs to control accurately, the embodiment of the present disclosure may be implemented. Since a gesture on the second area corresponds to the cursor on the first area, the gesture operation can be performed on the second display area, and a control on the first area can be controlled, thus making the gesture control more accurate, and reducing a misoperation. At the same time, because a combination between a gesture control on the first area and a gesture control on the second area is provided, a diversity of the gesture operation is increased, thus providing more application space for the flexible display screen, and further improving the user experience.

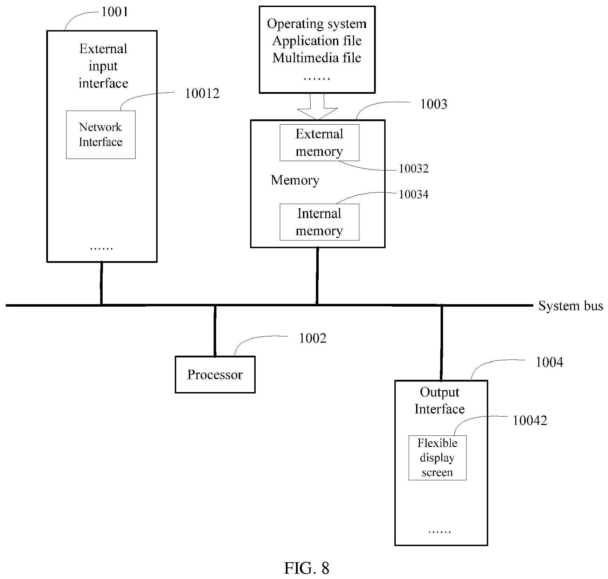

In an exemplary embodiment, as illustrated in FIG. 8, FIG. 8 illustrates a terminal device of a computer system 10 based on a von Neumann computer system which operates the above method for controlling the flexible display screen. The computer system 10 can be a terminal device, such as a smart phone, a tablet, a palmtop, a laptop, or a personal computer. Specifically, the computer system 10 further includes an external input interface 1001, a processor 1002, a memory 1003, and an output interface 1004, which are connected with each other by a system bus. Alternatively, the external input interface 1001 can include at least a network interface 10012. The memory 1003 may include an external memory 10032 (such as, a hard disk, an optical disk, or a floppy disk) and an internal memory 10034. The output interface 1004 may include at least a device, such as a flexible display 10042.

In the embodiment, the method is run based on the computer program. Program files of the computer program are stored in the external memory 10032 of the above computer system 10 based on a von Neumann computer system, which are loaded into the internal memory 10034 at runtime, compiled into a machine code, and then transmitted to the processor 1002 for processing, thus forming the logical bending operation detection module 102, first gesture obtaining module 104, gesture control module 106, second gesture obtaining module 108, cursor display module 110, and gesture determination module 112 in the computer system 10 based on the von Neumann computer system. In the implementation of the method for controlling the flexible display screen, input parameters received by the external input interface 1001 are transmitted to the memory 1003 for caching, and then input to the processor 1002 for processing. The processed result data is cached in the memory 1003 for subsequent processing, or transmitted to the output interface 1004 for output.

In detail, the processor 1002 is configured to perform the following steps.

A bending operation of the flexible display screen is detected, and the first area and the second area are determined according to the bending operation.

A first gesture operating on the second area of the flexible display screen is detected, and a gesture parameter of the first gesture is obtained. The gesture parameter includes at least one of a gesture type, a gesture direction, a gesture movement distance, a gesture duration, and a gesture pressure.

A target control on the first area is obtained according to the gesture parameter, and a control command corresponding to the target control is generated and performed.

Alternatively, obtaining the target control on the first area according to the gesture parameter includes:

obtaining a cursor or focus position on the first area according to the gesture parameter of the first gesture, and obtaining a target control corresponding to the cursor or focus position.

Alternatively, the method further includes:
when a second gesture operating on the first area is detected within a preset first time threshold, obtaining the target control on the first area according to the first gesture and the second gesture, then generating and performing the control command corresponding to the target control.

Alternatively, the method further includes:
when a third gesture operating on the second area of the flexible display screen is detected, displaying a cursor on the first area of the flexible display screen.

Alternatively, the method further includes:
detecting a window object displayed on the first area, and obtaining a window identifier of the window object; and
when the window identifier matches a preset value, displaying a cursor on an area of the first area corresponding to the window object.

Alternatively, the method further includes:
obtaining a gesture duration of the first gesture, the second gesture, or the third gesture, and when the gesture duration is less than a preset second time threshold, determining that the first gesture, the second gesture, or the third gesture is invalid.

Alternatively, gesture types of the first gesture, the second gesture, and the third gesture comprises at least one of a sliding, a click, a long pressing, and multi touch.

It will be understood by those of ordinary skill in the art that all or a part of the process of the method of the above embodiments described above may be accomplished by a computer program to instruct associated hardware, the program may be stored in a computer-readable storage medium. The program, when performed, may include the process of an embodiment of the method as described above. The storage medium may be a magnetic disk, an optical disk, a read-only memory (ROM), or a random access memory (RAM), and so on.

The above is only the preferable embodiment of the present disclosure, the scope of the present disclosure is not limited to thereof. It will be understood by those of ordinary skill in the art that all or a part of the process of the method of the above embodiments described above, and equivalent changes made in the claims of the present disclosure are still within the scope of the present disclosure.

## Claims

1. A method for controlling a flexible display device, which is performed by a flexible display screen, wherein a display interface of the flexible display screen comprises a first area and a second area upon being bent; and the method comprises:
detecting a bending operation of the flexible display screen, and determining the first area and the second area according to the bending operation;
detecting a first gesture operating on the second area of the flexible display screen, and obtaining a gesture parameter of the first gesture, wherein the gesture parameter comprises at least one of a gesture type, a gesture direction, a gesture movement distance, a gesture duration, and a gesture pressure; and
obtaining a target control on the first area according to the gesture parameter, and generating and performing a control command corresponding to the target control.

2. The method of claim 1, wherein obtaining the target control on the first area according to the gesture parameter comprises:
obtaining a cursor or focus position on the first area according to the gesture parameter of the first gesture, and obtaining a target control corresponding to the cursor or focus position.

3. The method of claim 1, wherein the method further comprises:detecting a second gesture operating on the first area is detected within a preset first time threshold, obtaining the target control on the first area according to the first gesture and the second gesture, and generating and performing the control command corresponding to the target control.

4. The method of claim 1, wherein the method further comprises:
when a third gesture operating on the second area of the flexible display screen is detected, displaying a cursor on the first area of the flexible display screen.

5. The method of claim 1, wherein the method further comprises:
detecting a window object displayed on the first area, and obtaining a window identifier of the window object;
when the window identifier matches with a preset value, displaying a cursor on an area of the first area corresponding to the window object.

6. The method of any one of claims 1 to 5, wherein the method further comprises:
obtaining a gesture duration of the first gesture, the second gesture, or the third gesture, and when the gesture duration is less than a preset second time threshold, determining that the first gesture, the second gesture, or the third gesture is invalid.

7. The method of any one of claims 1 to 5, wherein gesture types of the first gesture, the second gesture, and the third gesture comprise at least one of a sliding, a click, a long pressing, and multi touch.

8. A device for controlling a flexible display device, comprising:
a bending operation detection module configured to detect a bending operation of the flexible display screen, and determine the first area and the second area according to the bending operation;
a first gesture obtaining module configured to detect a first gesture operating on the second area of the flexible display screen, and obtain a gesture parameter of the first gesture; wherein the gesture parameter comprises at least one of a gesture type, a gesture direction, a gesture movement distance, a gesture duration, and a gesture pressure; and
a gesture control module configured to obtain a target control on the first area according to the gesture parameter, and generate and perform a control command corresponding to the target control.

9. The device of claim 8, wherein the first gesture obtaining module is further configured to:
obtain a cursor or focus position on the first area according to the gesture parameter of the first gesture, and obtain a target control corresponding to the cursor or focus position.

10. The device of claim 8, wherein the device further comprises a second gesture obtaining module configured to, when a second gesture operating on the first area is detected within a preset first time threshold, obtain the target control on the first area according to the first gesture and the second gesture, then generate and perform the control command corresponding to the target control.

11. The device of claim 8, wherein the device further comprises a cursor display module configured to, when a third gesture operating on the second area of the flexible display screen is detected, display a cursor on the first area of the flexible display screen.

12. The device of claim 8, wherein the cursor display module is further configured to detect a window object displayed on the first area, obtain a window identifier of the window object, and display a cursor on an area of the first area corresponding to the window object when the window identifier matches a preset value.

13. The device of any one of claims 8 to 12, wherein the device further comprises a gesture determination module configured to:
obtain a gesture duration of the first gesture, the second gesture, or the third gesture, and when the gesture duration is less than a preset second time threshold, determining that the first gesture, the second gesture, or the third gesture is invalid.

14. The device of any one of claims 8 to 12, wherein gesture types of the first gesture, the second gesture, and the third gesture comprises at least one of a sliding, a click, a long pressing, and multi touch.
